# EUROPÄISCHE PATENTANMELDUNG

(11) **EP 1 213 751 A2**
(43) Veröffentlichungstag der Anmeldung: **12.06.2002**
(21) Anmeldenummer: 01000680.7
(22) Anmeldetag: 29.11.2001
(51) Int. Cl.: H01L 21/60, H01L 23/15, H01L 23/498

(54) **Halbleiterbaugruppe mit einer Verbindungsstruktur**

(30) Priorität: 30.11.2000 DE 10059765
(71) Anmelder: Philips Corporate Intellectual Property GmbH, 52064 Aachen (DE); Koninklijke Philips Electronics N.V., 5621 BA Eindhoven (NL)
(72) Erfinder: Solo de Zaldivar, Jose, 52064 Aachen (DE); Baumgartner, Peter, 52064 Aachen (DE)
(74) Vertreter: Volmer, Georg, Dipl.-Ing.

(57) **Zusammenfassung**

Die Erfindung beschreibt eine Baugruppe ausgestattet mit einem Bauteil und einem Substrat (7). Das Bauteil und das Substrat (7) sind über Verbindungsstrukturen (6,8) elektrisch miteinander verbunden. Die erste Verbindungsstruktur (6) des Bauteiles enthält Aluminium, was die Herstellung der Baugruppe vereinfacht.

## Beschreibung

Die Erfindung betrifft eine Baugruppe ausgestattet mit einem Bauteil und einem Substrat, wobei das Bauteil eine erste Verbindungsstruktur und das Substrat eine zweite Verbindungsstruktur aufweisen, sowie mit einer zwischen dem Bauteil und dem Substrat befindlichen Zwischenschicht.

Zur Befestigung und elektrischen Kontaktierung eines Chips mit integriertem Schaltkreis auf einem Substrat können Gold-Bumps in Kombination mit sogenannten ACF-(Anisotropic Conductive Films)-Material verwendet werden. Dazu werden die Gold-Bumps auf dem Chip mit Kontaktbereichen auf dem Substrat ausgerichtet und über ACF-Materialien elektrisch miteinander verbunden.

Beim heutigen Stand der Halbleiterherstellungstechnik werden die Herstellung des Chips beziehungsweise des Wafers und die Herstellung der Gold-Bumps räumlich voneinander getrennt. Der Grund hierfür liegt in der Inkompatibilität der beiden Prozesse. Die Gold-Bumps werden mittels Plattierens der Chip-Oberfläche und anschließender lithographischer Strukturierung erzeugt. Gold als Edelmetall kann aber ganz leicht Teile der verwendeten Ausrüstung zur Herstellung des Wafers kontaminieren, was dramatische Konsequenzen für Ausbeute und Leistung des Wafers haben kann.

Die räumliche Trennung der beiden Herstellungsprozesse führt zu höheren Kosten, da beispielsweise eine kompliziertere Logistik nötig ist, mehr Reinräume geschaffen werden müssen und die Durchgangszeiten in den Fabriken höher sind.

Versuche, Bumps aus anderen Materialien als Edelmetallen herzustellen, scheiterten meist darin, dass die Bumps nicht kompatibel mit den Al-Pads auf den Chips waren, die als Zuleitungen der Schaltkreise auf den Chips dienen. So können beispielsweise weder Pt oder Pd mit den Al-Pads eines Chips kontaktiert waden, ohne dass sich spröde Legierungen der beiden Metalle ausbilden. Diese spröden Legierungen verschlechtern den elektrischen Kontakt.

In der US 5,563,449 ist ein Bump aus Pd, Pt oder Ni beschrieben. Zwischen dem Bump und dem Al-Pad sind noch zwei Zwischenschichten aufgebracht. Die erste Zwischenschicht ist eine Adhäsionsschicht aus Wolfram oder einer Wolfram-haltigen Legierung während die zweite Zwischenschicht Wolfram und ein Metall aus der Gruppe Pd, Pt und Ni mit einem Konzentrationsgradienten enthält.

Nachteilig ist, dass in dieser Struktur zwei zusätzliche Schichten aufgebracht werden müssen und dass die zweite Zwischenschicht einen Konzentratiensgefälle aufweisen muss, was die Abscheidung deutlich vertompliziert und den Herstellungsprozess verteuert.

Eine Aufgabe der vorliegende Erfindung ist, die Nachteile des Standes der Technik zu umgehen und eine Baugruppe mit einem Bauteil und einem Substrat bereitzustellen, die preiswert herzustellen ist.

Diese Aufgabe wird gelöst durch eine Baugruppe ausgestattet mit einem Bauteil und mit einem Substrat, wobei das Bauteil eine erste Verbindungsstruktur und das Substrat eine zweite Verbindungsstruktur aufweisen, sowie mit einer zwischen dem Bauteil und dem Substrat befindlichen Zwischenschicht, wobei die erste Verbindungsstruktur des Bauteiles Aluminium enthält.

Die Verwendung von Aluminium als Material für die erste Verbindungsstruktur vereinfacht und verbilligt die Herstellung des Bauteiles, da nur eine Schicht aufgebracht werden muss.

Es ist bevorzugt, dass das Bauteil ein Chip mit integriertem Schaltkreis, welcher eine oberste Metalllage aufweist, ist.

Durch Verwendung von Aluminium als Material für die erste Verbindungsstruktur (sogenannte Bumps) können diese in derselben Fabrik wie der Chip mit integriertem Schaltkreis hergestellt werden. Dadurch entfallen Transportkosten und die Logistik vereinfacht sich.

Außerdem können Aluminium-haltige Verbindungsstrukturen mittels Sputterns und bekannter photolithographischer Prozesse hergestellt werden. Diese Prozesse sind preiswerter und weit weniger aufwendig als der Prozess (Elektroplattieren) zur Herstellung von Goldhaltigen Verbindungsstrukturen. Weiterhin können mittels dieser Prozesse die Abstände zwischen den Verbindungsstrukturen kleiner gehalten werden. Dies ist für die Befestigung von immer komplexer werdenden integrierten Schaltkreisen von Vorteil.

Weiterhin weisen die gespurterten Aluminium-haltigen Verbindungsstrukturen eine uniforme Schichtdicke auf und Abweichungen in der Schichtdicke der ersten Verbindungsstrukturen liegen nur im nm-Bereich.

Es ist ganz besonders bevorzugt, dass die erste Verbindungsstruktur des Bauteiles direkt mit der obersten Metalllage des integrierten Schaltkreises verbunden ist.

Durch Versdung von Aluminium in der Verbindungsstruktur des Bauteiles brauchen keine Schichten zwischen der obersten Metalllage des integrierten Schaltkreises, den Al-Pads, und der ersten Verbindungsstruktur des Bauteiles aufgebracht werden. Der Kontakt kann beispielsweise einfach über ein Loch in der Schutzschicht des Chips mit integriertem Schaltkreis hergestellt werden. Das Loch wird bei der Herstellung der ersten Verbindungsstruktur mit Aluminium gefüllt.

Es ist bevorzugt, dass die Zwischenschicht ein ACF(Anisotropic Conductive Film)-Material enthält.

Mit einem ACF-Material, welches einen Kunstharz mit leitenden Partikeln enthält, wird eine kompakte, zusammenhängende Verbindung des Bauteiles und des Substrats erhalten. Durch Verwendung von Aluminium-haltigen ersten Verbindungsstrukturen am Bauteil, welche mit einer geringen Abweichung in der Schichtdicke hergestellt werden können, können die leitfähigen Partikeln des ACF-Materials einen kleineren Partikeldurchmesser aufweisen. Dadurch kann die Dichte an leitfähigen Partikeln innerhalb des ACF-Materials erhöht werden. Dies resultiert in einem niedrigen Kontaktwiderstand zwischen dem Bauteil und dem Substrat.

Es kann bevorzugt sein, dass die Zwischenschicht ein polymeres Material enthält.

Die Zwischenschicht kann zur Herstellung auch einer kompakten, zusammenhängende Struktur zwischen Bauteil und Substrat ein polymeres Material aufweisen. In dieser Ausführungsform erfolgt die elektrische Kontaktierung zwischen der ersten Verbindungsstruktur und der zweiten Verbindungsstruktur mittels Thermokompressions-Bonding. In diesem Fall werden die Aluminium-haltigen ersten Verbindungsstrukturen des Bauteiles direkt mit einer zweiten Verbindungsstruktur des Substrats, meist einer Kupfer-haltigen Zuleitung mit Goldbeschichtung, verbunden. Die entstehenden Zwischenräume sind in dieser Ausführung mit dem polymeren Material ausgefüllt.

Weiterhin ist es bevorzugt, dass das Substrat ausgewählt ist aus der Gruppe Glas und Folie.

Die fertigen Chips mit Aluminium-haltigen Verbindungsstrukturen können nach Verlassen der Fabrik sofort auf Glas (chip-on-glas, COG) oder Folie (chip-on-foil, COF) montiert werden.

Ausführungsbeispiele der Erfindung werden nachfolgend anhand der Zeichnungen näher erläutert. Dabei zeigen
- Fig. 1: im Querschnitt einen Chip, der auf Folie montiert ist,
- Fig. 2: im Querschnitt einen Chip, der mittels Thermokompressions-Bonding auf Folie montiert ist und
- Fig. 3: Im Querschnitt einen Chip, der auf Glas montiert ist.

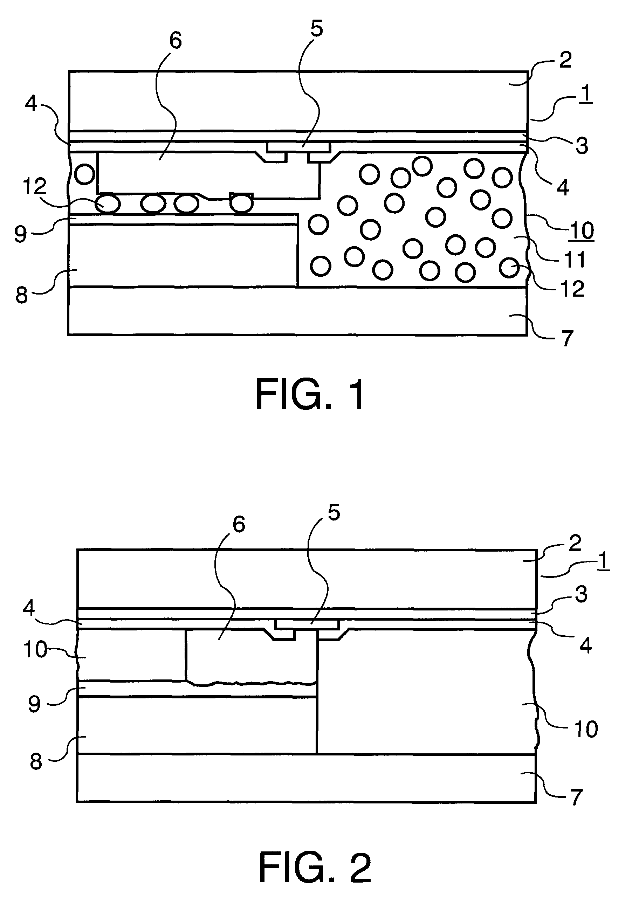

In Fig. 1 ist eine mögliche Baugruppe aus einem Bauteil und einem Substrat 7 gezeigt. In dieser Ausführungsform ist das Bauteil ein Chip 1 mit integriertem Schaltkreis. Der Chip 1 enthält ein halbleitendes Substrat 2, welches mittels verschiedenster Aufwachs-, Implantations- und Diffusionsprozesse mit aktiven Regionen versehen wurde, eine Isolationsschicht 3, eine Schutzschicht 4 und einen Kontakt 5. Die Isolationsschicht 3, welche beispielsweise SiO₂ enthält, dient zur elektrischen Isolation des Chips 1 von den Metalllagen des integrierten Schaltkreises, welche auf dem Chip 1 aufgebracht sind Als oberste Metalllage weist der Chip 1 mit integriertem Schaltkreis Kontakte 5 auf, welche aus Al, AlSi oder AlCu sind Über dem gesamten Chip 1 mit integriertem Schaltkreis ist eine Schutzschicht 4, welche zum Beispiel SiO₂ enthält, aufgebracht. Jeder Chip 1 mit integriertem Schaltkreis weist wenigstens eine erste Verbindungsstruktur 6, deren Schichtdicke vorzugsweise zwischen 2 und 6 µm liegt, auf. Die erste Verbindungsstruktur 6 enthält Al, AlSi oder AlCu und ist über einen Kontakt 5 direkt mit dem integrierten Schaltkreis des Chips 1 verbunden. Zur elektrischen Kontaktierung der ersten Verbindungsstruktur 6 mit einem Kontakt 5 weist die Schutzschicht 4 im Bereich eines Kontakts 5 eine Öffnung auf.

Der Chip 1 mit integriertem Schaltkreis ist in dieser Ausführungsform mit einer Folie als Substrat 7 verbunden. Die Folie kann beispielsweise Polyimid enthalten. Das Substrat 7 weist wenigstens eine zweite Verbindungsstruktur 8 auf, welche vorzugsweise Cu enthält. Die zweite Verbindungsstruktur 8 weist eine Beschichtung 9 aus beispielsweise Ni/Au auf. Die zweite Verbindungsstruktur 8 samt Beschichtung 9 wist vorzugsweise eine Höhe zwischen 10 und 15 µm auf. Die Schichtdicke der Beschichtung 9 beträgt vorzugsweise zwischen 200 und 500 nm. Die Kontaktierung zwischen der ersten Verbindungsstruktur 6 und der zweiten Verbindungsstruktur 8 des Substrats 7 wird mittels eines ACF-Materials, welches sich als Zwischenschicht 10 zwischen dem Chip 1 mit integriertem Schaltkreis und dem Substrat 7 befindet, hergestellt. Die Zwischenschicht 10 weist bevorzugt eine Schichtdicke zwischen 10 und 25 µm, vorzugsweise zwischen 10 und 20 µm, auf. Das ACF-Material enthält einen Kunstharz 11 mit leitfähigen Partikel 12. Die leitfähigen Partikel 12 sind beispielsweise Kugel aus Kunstharz, welche mit Au beschichtet sind. Der Durchmesser der leitfähigen Partikel 12 beträgt vorzugsweise zwischen 3 und 5 µm. Die erste Verbindungsstruktur 6 des Chips 1 mit integriertem Schaltkreis und die zweite Verbindungsstruktur 8 des Substrats 7 sind in dieser Ausführungsform nicht direkt miteinander verbunden, sondern die Verbindungsstrukturen 6,8 weisen einen Abstand zueinander auf, der maximal so groß sein sollte wie der Partikeldurchmesser der leitfähigen Partikel 12. Die elektrische Kontaktierung zwischen der ersten Verbindungsstruktur 6 des Chips 1 mit integriertem Schaltkreis und der zweiten Verbindungsstruktur 8 des Substrats 7 wird über die leitfähigen Partikel 12 hergestellt, welche sich zwischen den beiden Verbindungs-strukturen 6,8 befinden.

In Fig. 2 ist eine weitere mögliche Baugruppe mit einem Bauteil und einem Substrat 7 gezeigt. Auch in dieser Ausführungsform wird ein Chip 1 mit integriertem Schaltkreis auf eine Folie als Substrat 7 montiert. In dieser Ausführungsform werden die erste Verbindungsstruktur 6 des Chips 1 mit integriertem Schaltkreis und die zweite Verbindungsstruktur 8 des Substrat 7 über Thermokompressions-Bonding direkt miteinander verbunden. Zwischen dem Aluminium der ersten Verbindungsstruktur 6 und der Gold-Schicht der Beschichtung 9 aus Ni/Au der zweiten Verbindungsstruktur 8 bildet sich eine Interdiffusionsschicht mit gutem elektrischen Kontakt aus. Die Zwischenschicht 10 zwischen dem Substrat 7 und dem Chip 1 mit Schaltkreis ist in dieser Ausführungsform mit einem polymeren Material, wie beispielsweise einem Epoxidharz, ausfüllt.

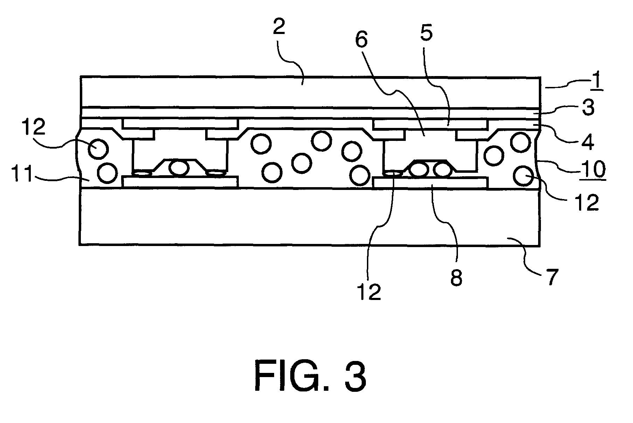

In Fig. 3 ist eine weiter erfindungsgemäße Baugruppe aus einem Bauteil und einem Substrat 7 gezeigt. In dieser Ausführungsform wird ein Chip 1 mit integriertem Schaltkreis auf Glas als Substrat 7 montiert. Die zweite Verbindungsstruktur 8 des Substrats 7 enthält in dieser Ausführungsform Indium-dotiertes Zinnoxid (ITO). Die elektrische Kontaktierung zwischen der ersten Verbindungsstruktur 6 und der zweiten Verbindungsstruktur 8 wird in dieser Ausführungsform über die leitfähigen Partikel 12 des ACF-Materials, welches sich in der Zwischenschicht 10 zwischen Chip 1 mit integriertem Schaltkreis und dem Substrat 7 befindet, hergestellt. Die Verbindungsstrukturen 6,8 weisen wiederum einen Abstand zu einander auf, der maximal dem Partikeldurchmesser der leitfähigen Partikel 12 entspricht.

Die Form der eisten Verbindungastruktur 6 des Bauteiles 1 ist beliebig und kann der gewählten Verbindungstechnik (Thermokompressions-Bonding oder Verwendung eines ACF-Materials) entsprechend gewählt werden. So tendieren die leitfähigen Partikel 12 des ACF-Materials dazu, aus dem Bereich zwischen den Verbindungsstrukturen 6,8 weg zu migrieren. Bei dieser Verbindungstechnik kann es von Vorteil sein, dass die Verbindungsstrukturen 6 des Bauteiles 1 je nach verwendeten Partikeldurchmesser der leitfähigen Partikel Oberflächenvertiefungen von 1 bis 4 µm Tiefe und einem Durchmesser zwischen 3 und 10 µm aufweisen. Vorzugsweise weisen die Verbindungsstrukturen 6,8 eine quaderförmige Form auf. Die drei Kantenlängen des Quaders weisen eine Größe im µm-Bereich auf.

## Patentansprüche

1. Baugruppe ausgestattet mit einem Bauteil und einem Substrat (7), wobei das Bauteil eine erste Verbindungsstruktur (6) und das Substrat (7) eine zweite Verbindungsstruktur (8) aufweisen, sowie mit einer zwischen dem Bauteil und dem Substrat befindlichen Zwischenschicht, wobei die erste Verbindungsstruktur (6) des Bauteiles Aluminium enthält.

2. Baugruppe nach Anspruch 1,
**dadurch gekennzeichnet,**
**dass** das Bauteil ein Chip mit integriertem Schaltkreis, welcher eine oberste Metalllage aufweist, ist.

3. Baugruppe nach Anspruch 2,
**dadurch gekennzeichnet,**
**dass** die erste Verbindungsstruktur (6) des Bauteiles direkt mit der obersten Metalllage des integrierten Schaltkreises verbunden ist.

4. Baugruppe nach Anspruch 1,
**dadurch gekennzeichnet,**
**dass** die Zwischenschicht (10) ein ACF(Anisotropic Conductive Film)-Material enthält.

5. Baugruppe nach Anspruch 1,
**dadurch gekennzeichnet,**
**dass** die Zwischenschicht (10) ein polmeres Material enthält.

6. Baugruppe nach Anspruch 1,
**dadurch gekennzeichnet,**
**dass** das Substrat (7) ausgewählt ist aus der Gruppe Glas und Folie.
